Europäisches Patentamt

European Patent Office

Office européen des brevets

(11) Publication number: **0 008 872**

A1

## EUROPEAN PATENT APPLICATION

(21) Application number: 79301534.8

(22) Date of filing: 31.07.79

(51) Int. Cl.³: **G 01 R 19/14**
**H 02 H 11/00**

(30) Priority: 15.08.78 JP 98709 78

(43) Date of publication of application:
19.03.80 Bulletin 80/6

(84) Designated Contracting States:
DE FR GB

(71) Applicant: NISSAN MOTOR COMPANY, LIMITED
No.2, Takara-cho, Kanagawa-ku
Yokohama-shi Kanagawa-ken(JP)

(72) Inventor: Inoue, Hiroshi
Nissan Kami-ohoka Shataku, 5-212 No. 3-4-5
Kami-ohoka-nishi Konan-ku Yokohama-City(JP)

(72) Inventor: Fukumori, Yukitsugu
No. 772, Nishiterao-cho
Kanagawa-ku, Yokohama City(JP)

(74) Representative: Freed, Arthur Woolf et al,
MARKS & CLERK 57-60 Lincoln's Inn Fields
London WC2A 3LS(GB)

(54) A circuit for indicating the reverse connection of connection leads with the terminals of an electromotive force source.

㉗ A circuit for indicating the reverse connection of connecting leads ( +, − ) with the terminals of a battery (4) has a diode (D8) connected to a vehicle horn driving circuit which includes a manual switch (8), a relay (7) responsive to the manual switch (8) and a horn (6) arranged to be energized by the relay. The diode (D8) is connected in parallel with the relay contacts (7b) so that the diode (D8) is biased in the forward direction when the battery (4) is connected in the reverse direction so that the horn (6) sounds to indicate that the battery (4) is connected incorrectly.

*FIG. 3*

EP 0 008 872 A1

Croydon Printing Company Ltd.

- 1 -

## "A CIRCUIT FOR INDICATING THE REVERSE CONNECTION OF CONNECTION LEADS WITH THE TERMINALS OF AN ELECTROMOTIVE FORCE SOURCE"

This invention relates to a circuit for indicating the reverse connection of connection leads with the terminals of an electromotive force source, such as a battery.

Usually positive and negative terminals of a battery have different sizes from each other so that a person who handles the battery does not connect the battery terminals to connection leads in the reverse direction. However, as to motor vehicle batteries, some cars are so arranged that the positive terminal of the battery is connected to the chassis of the vehicle, while other cars are so arranged that the negative terminal of the battery is connected to the vehicle chassis. Therefore, there is a fear that the positive and negative terminals of a battery might be incorrectly connected to the battery leads.

When the battery is connected to electrical circuits mounted on a vehicle in the reverse direction, some of electrical devices and elements are apt to be damaged by the application of a reverse-polarity voltage. Especially, semiconductive elements which are widely used in recent motor vehicles are easily damaged or broken upon connection of the power source in the reverse direction, since semiconductive elements have a poor characteristic against a reverse biased voltage.

In some electrical circuits, semiconductor diodes are connected in series with respective electrical circuits in such a manner that the series combinations of the diodes and electrical circuits are respectively interposed between positive and negative bus lines to prevent the circuit from being biased in the reverse direction, which may occur upon connection of the power source, such as a battery, to the bus lines via the connecting leads in the reverse direction. However, such a diode for preventing reverse voltage application has to be connected to each electrical circuit. Furthermore, since such a diode is normally conductive when the electrical circuit is in its "ON" state, power loss due to the voltage drop across the diode is not negligible.

A battery used for a motor vehicle is charged by an electric current which is generated in an alternator. An A.C. voltage generated in the alternator is applied to a rectifier which usually includes a plurality of diodes made of a semiconducting material. The A.C. voltage is converted by the rectifier into a D.C. voltage to charge the battery. Assuming that the battery is connected to the rectifier in the reverse direction, the battery is discharged via the diodes included in the rectifier. However, since the charging current from the rectifier is arranged to flow into the battery in a direction from the positive terminal of the rectifier to the positive terminal of the battery, a reverse-direction diode by which it is intended to prevent the reverse current, i.e. the discharging current, cannot be connected in series with the rectifier.

This invention has been developed in order to remove the above mentioned disadvantages and drawbacks inherent to electrical circuits which are arranged to be connected to a power source, such as a battery and it is an object of the present invention to provide a circuit for indicating the reverse connection of connection leads with the terminals of an electromotive force.

According to the present invention there is provided a circuit for indicating the reverse connection of connecting leads with the terminals of power source such as a battery, the connecting leads being respectively connected to positive and negative bus lines, the circuit having an alarm device and a diode connected directly or indirectly to the alarm device so that the diode is biased in the forward direction when the battery is incorrectly connected to the connecting leads so as to energise the alarm device.

Preferably, the alarm device is the vehicle horn which is energized upon the detection of the reverse connection of the battery.

The circuit is advantageous in that it utilizes a single diode.

The circuit gives an alarm which, if heeded, prevents the battery from being discharged via a charging circuit connected to the battery.

Embodiments of the present invention will now be described, by way of example, with reference to the accompanying drawings in which:-

Figure 1 shows a combination of a battery and a charging circuit;

Figure 2 shows a conventional reverse-voltage preventing circuit;

Figure 3 shows a circuit diagram of a first circuit according to the present invention;    and

Figure 4 shows a circuit diagram of a second circuit according to the present invention.

Prior to describing the preferred embodiments of the circuit according to the present invention, a battery charging circuit and a conventional reverse polarity current preventing circuit will be discussed for a better understanding of the embodiments of the present invention.

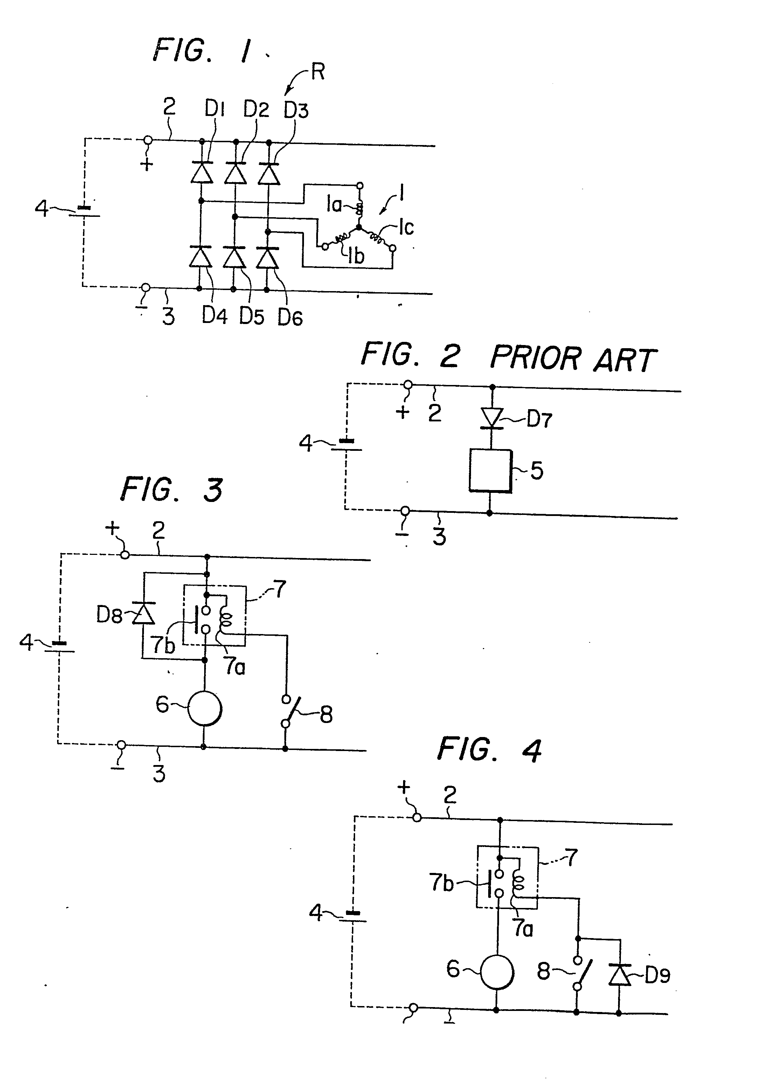

Figure 1 illustrates a normal battery charging circuit usually used in a motor vehicle. An alternator is generally denoted by a reference numeral 1, and has three armature coils 1a, 1b and 1c. A three-phase A.C. voltage is generated across the armature coils 1a, 1b and 1c and this A.C. voltage is supplied to a rectifier R which includes sic semiconductor diodes D1 to D6. These six diodes D1 to D6 are connected between a positive bus line 2 and a negative bus line 3 in such a manner that three pairs of series combinations of two diodes are interposed between the positive and negative bus lines 2 and 3. Corresponding ends of the three armature coils 1a, 1b and 1c are connected together and the other ends of the coils 1a, 1b and 1c are connected to the junction between the two diodes of respective series circuits. The positive and negative bus lines 2 and 3 are respectively connected to positive and negative connecting leads (+) and (-) to which positive and negative terminals of a battery 4 are respectively connected. The battery 4 is, however, shown to be incorrectly connected. The polarity of the battery connection is reverse and therefore, the connection is shown by dotted lines.

Assuming that the battery 4 is connected to the connecting leads 2 and 3 in such a direction as shown in Figure 1, all of the diodes D1 to D6 are biased in the forward direction so that a large amount of current flows via each of the diodes D1 to D6. In other words, the forwardly biased diodes D1 to D6 function as a short circuit and therefore, these diodes will be damaged within several tens of seconds. Not only these diodes D1 to D6 but the battery 4 itself will be damaged because of the enormous current flowing therethrough. However, it will be understood that a reverse-current preventing diode cannot be inserted in the opposite direction with respect to the diodes D1 to D6 in either the positive or negative bus line 2 or 3 since such a diode prevents the battery 4 from being charged.

Figure 2 illustrates a conventional reverse-current preventing circuit. A diode D7 is connected in series with an electrical circuit 5 and the series circuit is interposed between positive and negative bus lines 2 and 3 to which a battery 4 will be connected. When the battery 4 is connected incorrectly as shown in Figure 2, no current flows via the electrical circuit 5 since the diode D7 is biased in the reverse direction. However, it will be understood that such a reverse-current preventing diode has to be connected to each of electrical circuits connected between the positive and negative bus lines 2 and 3.

In the illustrated embodiments of the present invention, a vehicle horn is energized upon incorrect connection of the battery so that the person changing the battery will notice that the battery is connected to the battery leads in the reverse direction and will disconnect the battery as soon as possible.

Reference is now made to Figure 3 which shows a first preferred circuit according to the present invention. A vehicle horn 6 is connected between positive and negative bus lines 2 and 3 via a relay 7 which has a winding 7a and relay contacts 7b. The winding 7a is connected between the positive and negative bus lines 2 and 3 via a manual switch 8 which is usually disposed on the steering wheel (not illustrated) of the vehicle. The bus lines 2 and 3 are respectively connected to battery connecting leads (+) and (-) to be connected to the positive and negative terminals of the battery 4. Although Figure 3 does not show a charging circuit such as shown in Figure 1, a suitable charging circuit, which may include an alternator driven by the engine crankshaft and a rectifier, may be connected to the bus lines 2 and 3 to charge the battery 4. The above described construction of a vehicle horn driving circuit is of a conventional type. In the first embodiment of the present invention, a diode D8 is additionally provided and connected in parallel with the relay contacts 7b. In other words, the anode of the diode D8 is connected to one stationary contact of the relay contacts 7b, which contact is connected to one terminal of the horn 6, while the cathode of the diode D8 is connected to the positive bus line 2. This means that the diode D8 is connected in parallel with the relay contacts 7b in the reverse direction with respect to the normal voltage which is expected to be applied to the connecting leads (+) and (-).

The circuit shown in Figure 3 operates as follows. When a battery 4 is connected to the connecting leads (+) and (-) correctly, no current flows via the horn 6 unless the relay contacts 7b are closed since the diode D8 is biased in the reverse direction. The manual switch 8 may be operated to energize the relay 7 to close the contacts 7b thereof. As the result an electrical current flows from the positive terminal of the battery 4 via the positive connecting lead (+), the positive bus line 2, and the relay contacts 7b to the horn 6 so that the horn 6 sounds.

It is assumed that a battery which has been connected to the connecting leads (+) and (-) correctly, is disconnected to change batteries. It is further assumed that a new battery 4 is connected to the connecting leads (+) and (-) in the reverse direction as shown by the dotted lines in Figure 3. In this case the positive voltage is applied to the negative connecting lead (-), while the negative voltage is applied to the positive connecting lead (+). Accordingly, an electric current flows from the positive terminal of the battery 4 via the negative bus line 3, the horn 6, and the diode D8 irrespectively of the state of the relay contacts 7b. The horn 6 is sounded to make the person, who is changing the battery, realize that the battery 4 is incorrectly connected to the connecting leads (+) and (-). It is, therefore, expected that the person immediately disconnects the battery 4 from the connecting leads (+) and (-). Although the reverse voltage has been applied via the bus lines 2 and 3 to electrical circuits (not shown) for a period of time that the battery 4 is incorrectly connected to the connecting leads (+) and (-), if the voltage application period is only a few seconds, electrical elements, such as semiconducting elements, included in the electrical circuits are not damaged. In other words, electrical elements which are apt to be damaged by the application of the reverse voltage are not usually damaged unless the reverse voltage is applied for more than several tens of seconds. Furthermore, usually each of electrical circuits has its own power switch and therefore, application of a reverse voltage to the positive and negative bus lines 2 and 3 does not directly cause these electrical circuits to receive the reverse voltage if these power switches are open.

Reference is now made to Figure 4 which shows a second preferred embodiment of the present invention. The circuit is similar to that shown in Figure 3 except that diode D8 is omitted and a diode D9 is connected in parallel with the manual switch 8 in the direction such that the diode D9 is biased in the forward direction when the battery 4 is incorrectly connected to the connecting leads (+) and (-). Although the diode D9 is not conductive when biased in the reverse direction upon the correct connection of the battery 4, when the battery 4 is connected to the connecting leads (+) and (-) incorrectly as illustrated, an electrical current flows via the diode D9 and the winding 7a of the relay 7 irrespectively of the state of the manual switch 8. Consequently, the winding 7a is energized to close the contacts 7b so that the horn 6 is actuated in the same manner as in the first embodiment. Since the electrical current required for energizing the winding 7b of the relay 7 is much smaller than the current flowing through the horn 6, a diode having smaller rated forward current, such as less than one ampere, compared with that of the diode D8 in Figure 3, may be used.

Although in the above described embodiments the vehicle horn 6 is used as an alarm device, a suitable alarm device such as a buzzer or a lamp may be used in place of the horn 6. From the foregoing it will be understood that the circuit according to the present invention indicates the reverse connection of the power source with the connection leads (+) and (-), and therefore, the electrical circuits connected to the power source are prevented from being damaged. When a conventional vehicle horn is used as the alarm device, a single diode D8 or D9 may be additionally connected to either the contacts 7b of the relay 7 or the manual switch 8 to provide a reverse-connection indicating circuit. Of course, such a diode D8 or D9 may be built into either the relay 7 or the manual switch 8 when these elements are manufactured.

CLAIMS:

1.  A circuit for indicating the reverse connection of connecting leads (+, -) with the terminals of power source such as a battery (4), the connecting leads being respectively connected to positive and negative bus lines (2, 3), the circuit being characterised by an alarm device (6) and a diode connected directly or indirectly to the alarm device (6) so that the diode is biased in the forward direction when the battery (4) is incorrectly connected to the connecting leads (+, -), so as to energize the alarm device (6).

2.  A circuit according to claim 1 characterised by an alarm device driving circuit including a manual switch (8) and relay (7) responsive to the manual switch (8), the relay (7) being connected to the alarm device (6) in series between the bus lines (2, 3), the diode being connected to the driving circuit in such a manner that the diode is biased in the forward direction when the battery (4) is incorrectly connected to the connecting leads (+, -) so as to energize the alarm device (6).

3.  A circuit according to claim 2, characterised in that the diode (D8) is connected in parallel with the contacts (7b) of the relay (7).

4.  A circuit according to claim 2, characterised in that the winding (7a) of the relay (7) and the manual switch (8) constitute a series circuit which is connected between the bus lines (2,3) and the diode (D9) connected in parallel with the manual switch (8).

5.  A circuit according to any of claims 1 to 4 characterised in that the alarm device is a horn.

0008872

6.- A circuit according to any of claims 1 to 5, characterised by a charging circuit (R) for the battery (4).

0008872

FIG. 1.

FIG. 2 PRIOR ART

FIG. 3

FIG. 4

European Patent Office

**EUROPEAN SEARCH REPORT**

Application number

EP 79 30 1534

| | **DOCUMENTS CONSIDERED TO BE RELEVANT** | | CLASSIFICATION OF THE APPLICATION (Int. Cl. 3) |
|---|---|---|---|
| Category | Citation of document with indication, where appropriate, of relevant passages | Relevant to claim | |
| X | CA - A - 914 755 (G.C. HUNT et al.)<br>* Pages 3 to 7; figures 1-2 *<br><br>-- | 1,5-6 | G 01 R 19/14<br>H 02 H 11/00 |
| | US - A - 3 308 365 (H. JOHN)<br>* Column 2, lines 7-70; figures 1-3 *<br><br>-- | 1,6 | |
| | US - A - 3 879 655 (MITSURU SAITO)<br>* Column 4, lines 46-52; figures 1 and 8 *<br><br>-- | 1 | **TECHNICAL FIELDS SEARCHED (Int.Cl. 3)**<br><br>H 02 H 11/00<br>G 01 R 19/14 |
| | US - A - 3 398 347 (A.M. CITRO)<br>* Column 2, lines 25-41; figure *<br><br>-- | 1,6 | |
| | IBM TECHNICAL DISCLOSURE BULLETIN, vol. 17, no. 5, October 1974 New York (US) L.R. PALOUNEK and R.O. SKATRUD: "Polarity tester for two-wire serial loop communications system", page 1448.<br>* Page 1448, 2nd paragraph; figure *<br><br>---- | 1 | **CATEGORY OF CITED DOCUMENTS**<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

The present search report has been drawn up for all claims

| Place of search | Date of completion of the search | Examiner |
|---|---|---|
| The Hague | 23-11-1979 | KUSCHBERT |

EPO Form 1503.1  06 78